# EUROPEAN PATENT APPLICATION

(11) **EP 1 887 590 A1**
(43) Date of publication of application: **13.02.2008**
(21) Application number: 07253149.4
(22) Date of filing: 10.08.2007
(51) Int. Cl.: H01G 4/33, H01G 4/12

(54) **Method of forming individual formed-on-foil thin capacitors**

(30) Priority: 10.08.2006 US 502019
(71) Applicant: E.I. du Pont de Nemours and Company, Wilmington, DE 19898 (US)
(72) Inventor: Borland, William, Chapel Hill, North Carolina 27517 (US); Amey, Daniel Irwin, Jr., Durham, North Carolina 27705 (US); McGregor, David Ross, Apex, North Carolina 27539 (US); Onken, Matthew T., Cary, North Carolina 27519 (US)
(74) Representative: Towler, Philip Dean

(57) **Abstract**

Disclosed is a method of forming individual thin-film capacitors for embedding inside printed wiring boards or organic semiconductor package substrates, which includes removal of selected portions of the capacitor by sandblasting or other means so that the ceramic dielectric does not come into contact with acid etching solutions.

## Description

### FIELD OF THE INVENTION

The technical field is embedded capacitors in printed wiring boards (PWB). More particularly, the technical field includes embedded thin ceramic capacitors in printed wiring boards or semiconductor packages made from formed-on-foil thin dielectrics.

### BACKGROUND OF THE INVENTION

The practice of embedding formed-on-foil (typically, fired-on-foil) ceramic capacitors in printed wiring boards allows for reduced circuit size and improved circuit performance. Ceramic capacitors are typically embedded in inner layer panels that are stacked and connected by interconnection circuitry, the stack of panels forming a multilayer printed wiring board or semiconductor package substrate. Embedded formed-on-foil ceramic capacitors preferably have a high capacitance density.

The capacitance density of a dielectric is proportional to its dielectric constant, divided by the thickness of the dielectric. A high capacitance density capacitor can therefore be achieved by using a thin, high dielectric constant dielectric in the capacitor.

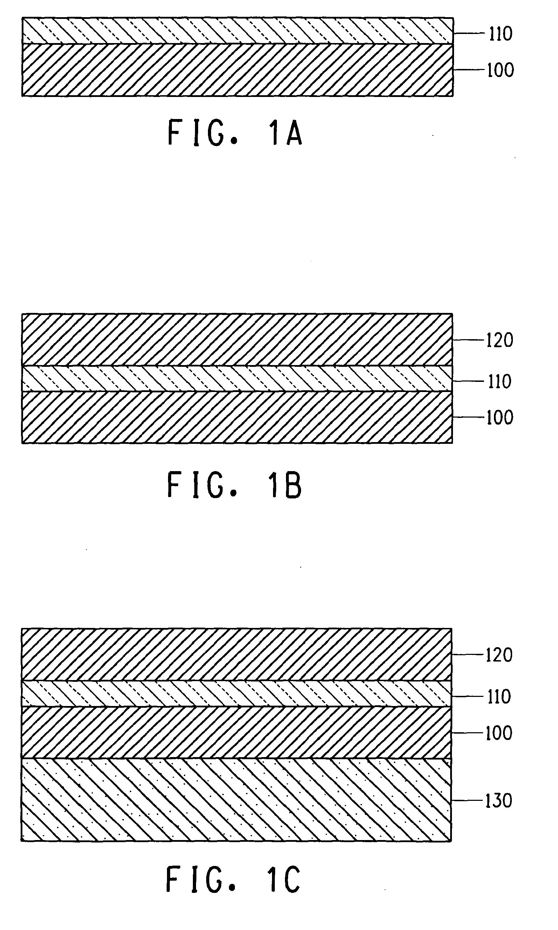

Passive circuit components embedded in printed circuit boards formed by formed-on-foil thin ceramic dielectric technology are known. A formed-on-foil thin-film process is disclosed in U.S. Patent No. 7,029,971 to Borland et al. Referring to **FIG. 1A,** formed-on-foil thin ceramic capacitors are formed by first depositing a thin capacitor dielectric material layer **110** onto a metallic foil substrate **100.** The metallic foil substrate **100** may be copper foil and typically may range in thickness between 12 and 36 µm. The thin capacitor dielectric layer may be deposited by screen-printing, slurry casting, chemical solution deposition, sputtering, chemical vapor deposition or any other recognized thin layer deposition method. The thin capacitor dielectric material may be subjected to a firing or annealing process to crystallize the deposited material, and increase the dielectric constant. After firing, the thin dielectric layer will generally be a homogenous ceramic layer and may range in thickness from approximately 12 µm to substantially less than 1 µm. The firing process may be conducted at relatively low temperatures in air or at higher temperatures in reduced oxygen atmospheres. The thin ceramic capacitor dielectric material may comprise a high dielectric constant material and have a high dielectric constant after firing. A metallic electrode material is next deposited over the formed-on-foil thin ceramic capacitor dielectric layer. The metallic electrode generally would cover the entire layer of the ceramic dielectric. The deposition method can be any of a number of deposition methods. Sputtering is generally the preferred choice. The metallic electrode may be plated with additional metal to build the electrode up to a desired thickness, such as that of the metallic foil substrate **100,** and form electrode **120** in **FIG. 1B.** The resulting metal/dielectric/metal structure, shown in **FIG. 1B,** may be laminated to an underlying organic based dielectric layer such as a glass epoxy or other common organic dielectric used in the printed wiring board industry using a prepreg dielectric layer to form the dielectric layer **130** and create the article shown in **FIG. 1C.**

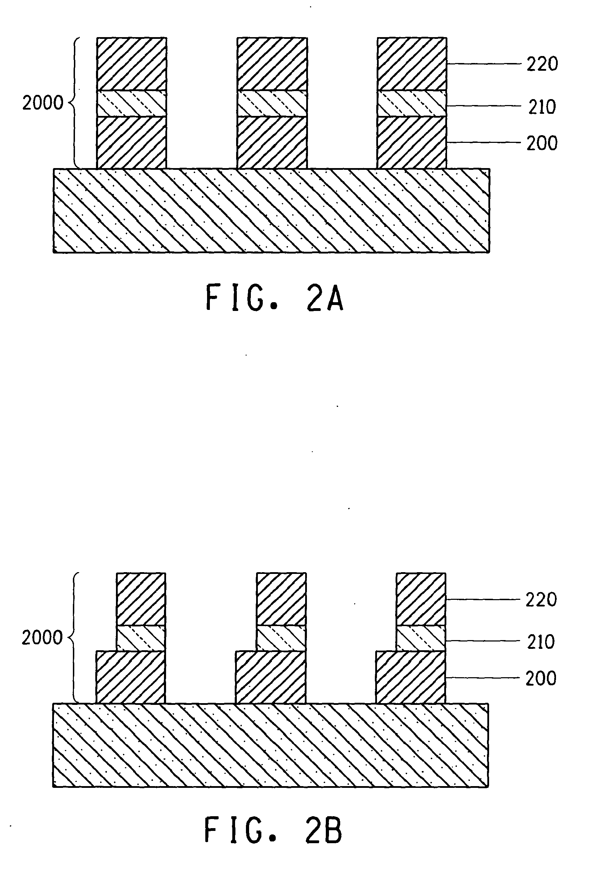

A series of masking and etching processes is generally undertaken to selectively remove portions of the metallic foil and the thin ceramic capacitor dielectric to form individual capacitors. Two examples of such resulting structures are shown in **FIG. 2A** and **2B** wherein the individual capacitors **2000** consist of a first electrode **200,** a thin ceramic capacitor dielectric layer **210** and a second electrode **220.** In the design shown in **FIG. 2A,** after incorporation in the printed wiring board, the capacitor electrodes are accessed from top and bottom by use of vias. In the design shown in **FIG. 2B,** after incorporation in the printed wiring board, both capacitor electrodes may be accessed from the top using vias. Other designs may be practiced. In order to remove copper, either acid-based or alkaline-based etching chemistries may be used. In general, alkaline etching solutions do not readily remove the ceramic dielectric, but strong acid solutions will. Examples of acids that dissolve ceramic are ferric chloride or cupric chloride in hot 2.4 N hydrochloric acid, or hydrofluoric acid chemistries. Even with such acids, the rate of removal of the ceramic is slow. However, there is an additional consideration that when using an acid, such as hydrochloric acid, the acid and any products of the dissolution have to be completely removed. It is well known that chloride contamination can cause migration issues under bias and humidity in ceramic dielectrics. Therefore, if the acid etching solution or any products from the ceramic dissolution have not been thoroughly removed from the capacitor, the long-term reliability of the capacitor may be compromised.

### SUMMARY OF THE INVENTION

The present invention provides a method of making individual formed-on-foil thin ceramic capacitors comprising: providing a structure, said structure comprising a first metallic conductor, a ceramic dielectric, and a second metallic conductor; forming a photo-definable mask over at least one of said metallic conductors, thus forming an article comprising a first photo-definable mask with underlying first metallic conductor, a ceramic dielectric and an opposing second metallic conductor; and removing selected portions of said first photo-definable mask and said underlying first metallic conductor to form a patterned first side of said article comprising a first metallic electrode.

According to one embodiment, a method of making individual thin formed-on-foil ceramic capacitors further comprises removal of the ceramic dielectric and metallic conductor (typically copper) by removal means, such as sandblasting as an alternative method to selectively removing ceramic and copper with acid based etchants. The patterning may be achieved by sandblasting through a photo-defined mask, such as a mask made from Riston® photoimageable dry film photoresist or preferably a wholly dry processing resist approach such as the use of RapidMask™ available from IKONICS Company, PhotoBrasive Systems, Duluth, MN.

According to a further embodiment, a method of making individual thin formed-on-foil ceramic capacitors comprises patterning a first electrode by use of an alkali etchant and using the patterned first electrode and the photoresist mask (or RapidMask™) as a mask and sandblasting to selectively remove the ceramic between the first electrodes; stripping (defined herein as removal) the first photomask and applying a second photoresist photomask to protect the first electrode and the thin ceramic dielectric and patterning a second electrode by etching.

According to the above embodiments, the ceramic dielectric of the capacitor does not come into contact with acid etching solutions during fabrication of the individual capacitors. The acid etching solutions may otherwise damage the ceramic dielectric or leave deposits that would compromise the long-term reliability. Capacitor reliability and performance are thereby improved.

### BRIEF DESCRIPTION OF THE DRAWINGS

The detailed description will refer to the following drawings wherein:
**FIGS. 1A-C** are cross-sectional views showing formed-on-foil thin ceramic capacitors.
**FIGS. 2A-2B** are cross-sectional views showing individual capacitor structures.
**FIGS. 3A-3F** are a series of views illustrating a method of manufacturing individual formed-on-foil thin ceramic capacitors, according to an embodiment of the invention wherein selected portions of the copper foil and ceramic dielectric are removed by sandblasting through a photo-defined mask;

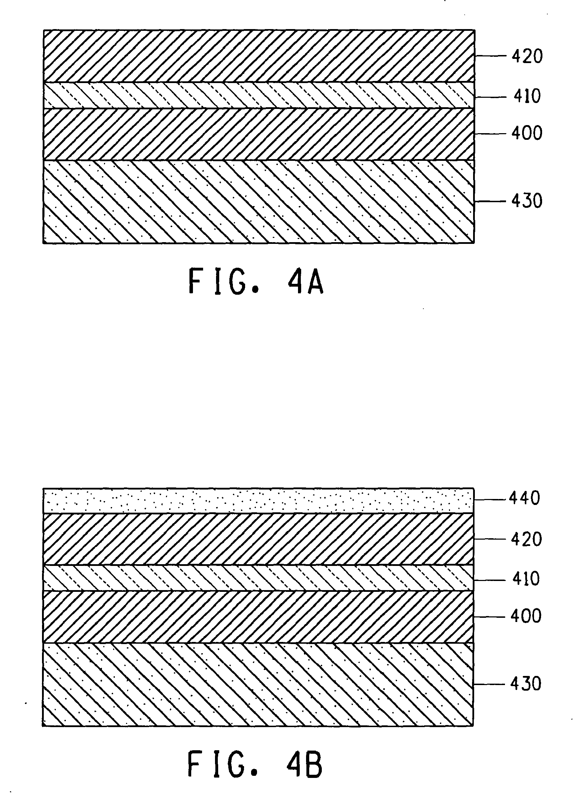

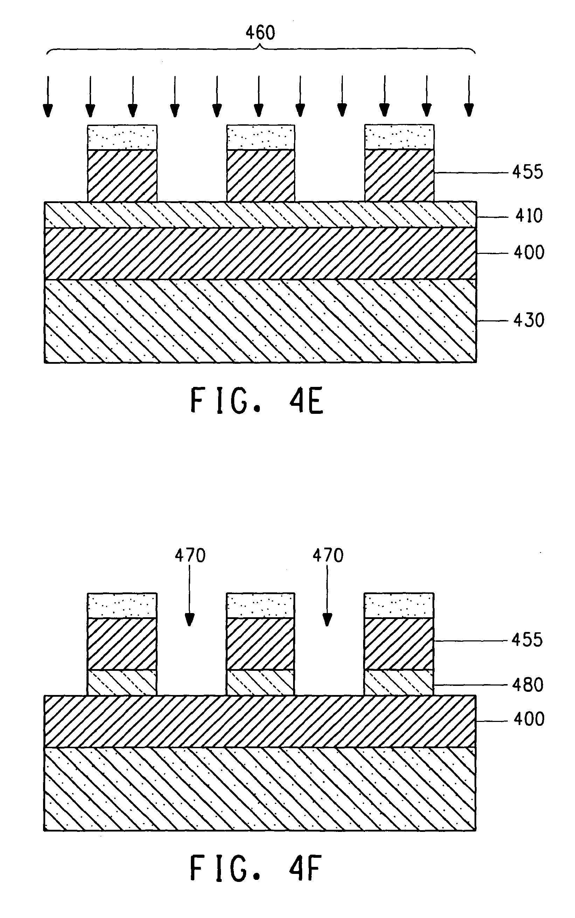

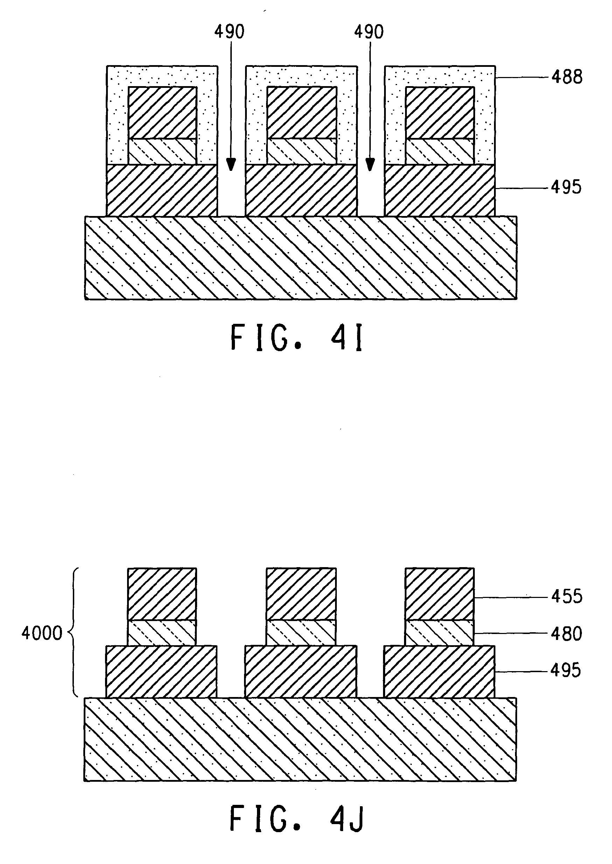

**FIGS. 4A-4J** are a series of views illustrating a method of manufacturing individual formed-on-foil thin ceramic capacitors, according to an embodiment of the invention wherein the first electrode is formed using an alkali etching process. The formed first electrode plus the photo-defined mask protecting it is used to protect the underlying ceramic dielectric when the ceramic dielectric between the first electrode is removed by sandblasting. After sandblasting away the thin ceramic dielectric, the photomask is removed and replaced by another photoresist that is imaged to form another photomask that serves to protect the first electrode and the thin ceramic dielectric while the second electrode is patterned by etching.
**FIGS. 5A-5M** are a series of views illustrating a method of manufacturing individual formed-on-foil thin ceramic capacitors according to a further alternative embodiment of the invention, wherein the first electrode is formed on a first side of the formed-on-foil metal/dielectric/ metal structure, shown in **FIG. 1B,** and said first side is laminated to an additional metal conductor using a prepreg material and then a second electrode is formed on the second side of said formed-on-foil metal/dielectric/metal structure and the exposed thin ceramic dielectric is removed by sandblasting.
According to common practice, the various features of the drawings are not necessarily drawn to scale. Dimensions of various features may be expanded or reduced to more clearly illustrate the embodiments of the invention.

### DETAILED DESCRIPTION OF THE INVENTION

Contiguous sheets of metal are referred to as "metal conductor" and formed capacitor plates as "metal electrodes". These references are simply done for purposes of clarity and are not intended to be limiting. Additionally, in some embodiments, these metallic conductors and metallic electrodes are copper foil or formed from copper foil. Any reference to copper or copper foil is not intended to be limiting only to copper or copper foil but is to be thought of as an example of a metal conductor.

The present invention provides a method of making individual formed-on-foil thin ceramic capacitors comprising: providing a structure, said structure comprising a first metallic conductor, a ceramic dielectric, and a second metallic conductor; forming a photo-definable mask over at least one of said metallic conductors, thus forming an article comprising a first photo-definable mask with underlying first metallic conductor, a ceramic dielectric and an opposing second metallic conductor; and removing selected portions of said first photo-definable mask and said underlying first metallic conductor to form a patterned first side of said article comprising a first metallic electrode. A further embodiment of the present invention further comprises the step of essentially completely removing said first photo-definable mask, thus forming an essentially mask-free patterned first side of said article. In another embodiment, the individual formed-on-foil thin ceramic capacitors are laminated to an organic dielectric layer.

The present invention further provides a method of making individual formed-on-foil thin ceramic capacitors (as noted above) wherein selected portions of at least one of said underlying first metallic conductor and said ceramic dielectric and said opposing metallic conductor are removed by a process selected from the group comprising sandblasting, water impingement, and chemical etching.

The following descriptions and figures further represent various embodiments of the present invention.

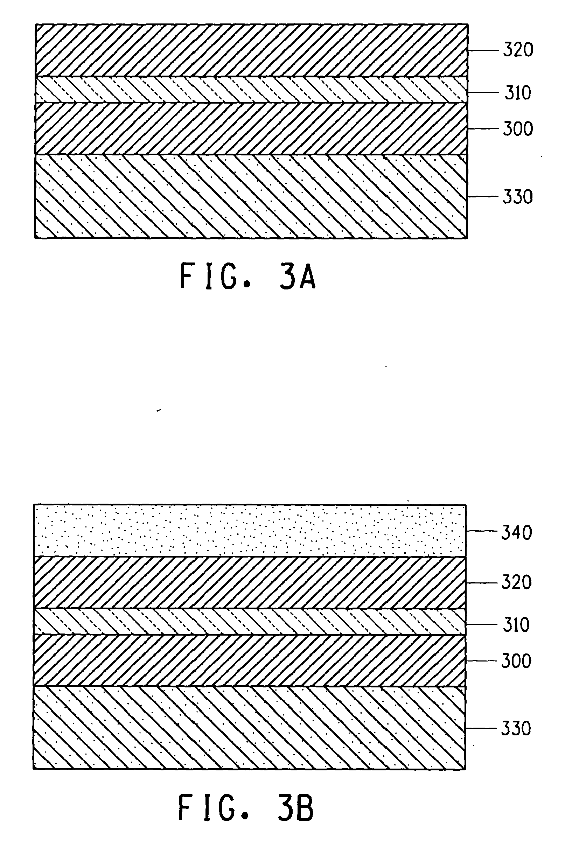

FIGS. **3A-3F** illustrate a first method of manufacturing individual formed-on-foil thin ceramic capacitors wherein the ceramic dielectric and metallic conductor (typically copper) are removed by sandblasting (or other removal means such as water impingement, water/slurry impingement, water/abrasive impingement, abrasive removal, laser guided water jetting, and chemical etching, etc.) through a mask (photo-definable mask) that is used to protect areas that will form the capacitors. The photo-definable mask as used herein may also be referred to as a mask, photoresist, photoresist mask, etc. Once imaged, the photoresist or photo-definable mask forms the photomask.

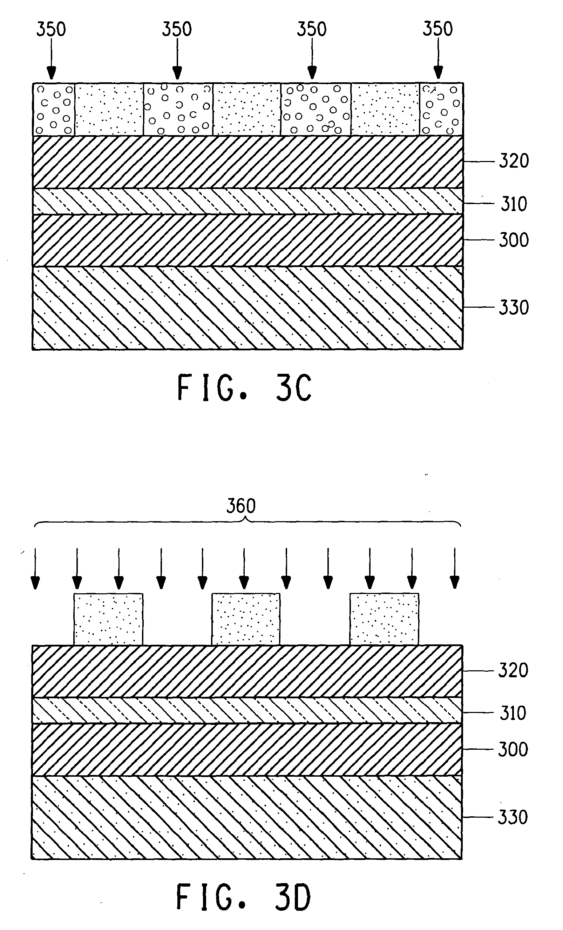

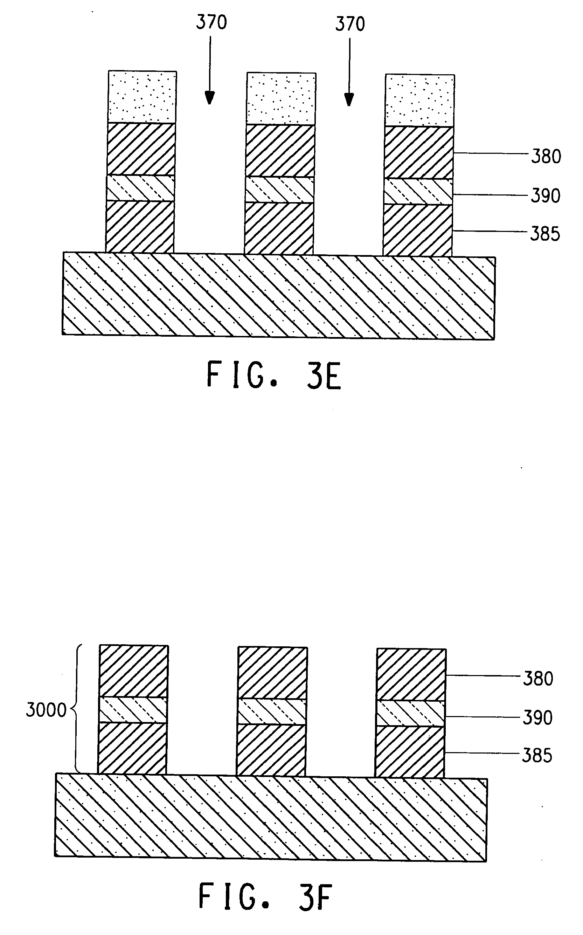

Referring to **FIG. 3A,** a thin ceramic capacitor dielectric **310** sandwiched between metallic conductors (typically copper) **300** and **320** and laminated to organic dielectric **330** is provided. Referring to **FIG. 3B,** a photoresist material **340** is applied to the copper foil **320.** A dry processing resist, such as RapidMask™ available from PhotoBrasive Systems is preferable but other photoresists that are resistant to impact by sandblasting media (or other media chosen for removal) may be used. As shown in **FIG. 3C,** after the photoresist has been exposed with UV radiation, the photoresist becomes brittle in the areas **350** where the photoresist has been exposed. As shown in **FIG. 3D,** the abrasive media (typically sand) **360** impinges on the resist surface and breaks up and removes the brittle exposed resist features while the sand bounces off the unexposed, compliant, rubbery resist features without damaging these areas. Once the exposed, brittle resist has been blasted off, the sand removes material in the areas **370** forming individual electrodes **380** and **385** and dielectric **390** as shown in **FIG. 3E.** When sandblasting is complete, the non-exposed resist is removed (stripped) from the substrate surface to form the individual capacitors **3000** as shown in **FIG. 3F.** One or more individual capacitors may be formed. Those skilled in the art understand that photoresist (and/or metallic electrode and/or ceramic dielectric) removal may be accomplished by means other than sandblasting. For example, removal by water impingement including: 1) water alone; 2) water and slurry or abrasive; 3) laser guided water jetting or by chemical etching. The use of "sandblasting" in the descriptions of the embodiments below is not intended to be limiting.

The above process may be partially repeated, for example, to form the article shown in **FIG. 2B.** In this case, an additional photoresist mask may be applied to all the individual electrodes **380** shown in **FIG. 3F** and a portion of the top electrode **380** and the dielectric **390** removed by sandblasting. The process would be stopped prior to removal of any of the bottom electrode **385** so that the article shown in **FIG. 2B** is formed.

FIGS. **4A-4J** illustrate a second method of manufacturing individual formed-on-foil thin ceramic capacitors wherein the first electrode is formed using alkali etching processes. The formed first electrode and the photomask protecting it are used to protect the underlying dielectric during sandblasting. The sandblasting removes the dielectric between the formed first electrodes. The photomask is stripped (or removed) and replaced by another photoresist photomask so that the second electrode can be formed using an alkaline etching process.

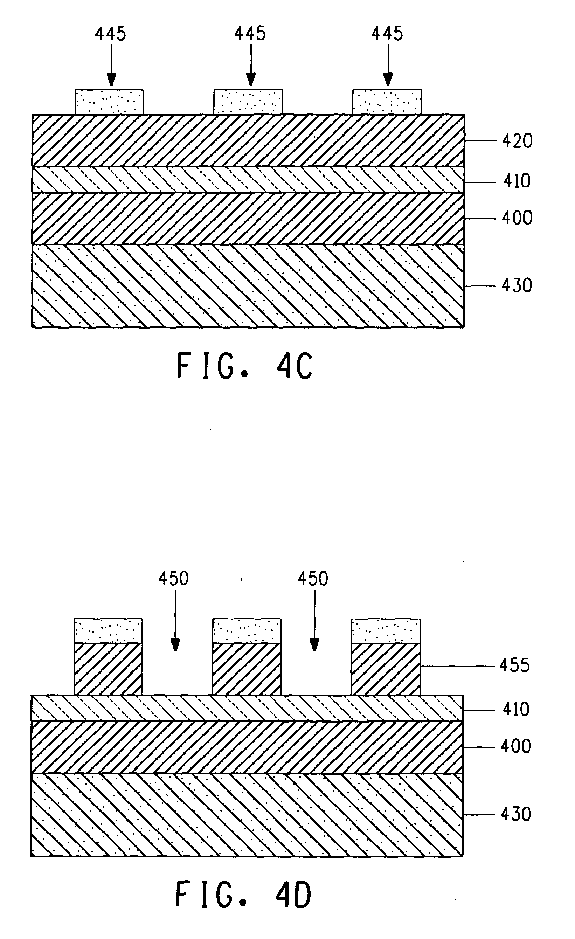

Referring to **FIG. 4A,** a thin film capacitor dielectric **410** sandwiched between metallic conductors **400** and **420** and laminated to an underlying organic dielectric layer using a prepreg dielectric layer to form organic dielectric **430** is provided. The article is essentially similar to and manufactured in the same manner as the article described in **FIG 1C.** Referring to **FIG: 4B,** a photoresist material **440** is applied to the copper foil **420.** The photoresist is imaged and developed to form the photomask **445** as shown in **FIG. 4C.**

The article shown in **FIG. 4C** is now subjected to an alkaline etching bath. The alkali etching process removes the copper in the areas **450** shown in **FIG. 4D** and forms the first electrode **455.** The alkaline etch does not attack or remove any of the dielectric **410.** Referring to **FIG. 4E,** the article of **FIG. 4D** is subjected to sandblasting. The sandblasting removes the dielectric in the areas **470** shown in **FIG. 4F** and forms the individual dielectric layers **480.**

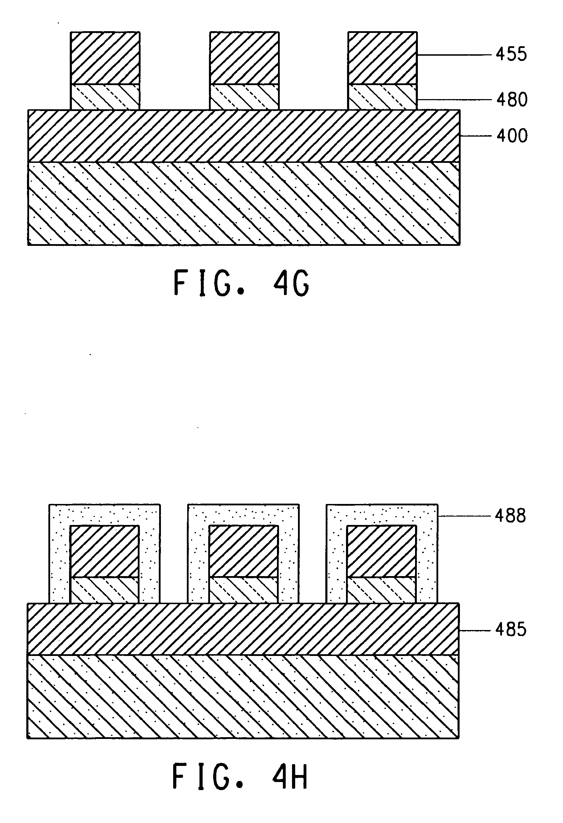

Referring to **FIG. 4G,** the photomask **445** may now be removed and replaced by another photoresist that is imaged to form the photomask **488** shown in **FIG. 4H.** The copper foil **485** may now be removed (i.e., by etching using acid or alkali etching solutions or other methods known to those skilled in the art) in the area **490** to form second electrodes **495** and the article shown in **FIG. 41.** Finally, the photomask **488** can be stripped to form the individual capacitors **4000** as shown in **FIG. 4J.**

The above process may be modified to form alternative designs. For example, the second photomask **488** may be expanded along the foil **485** so that when the foil **485** is etched, the article shown in **FIG. 2B** is formed.

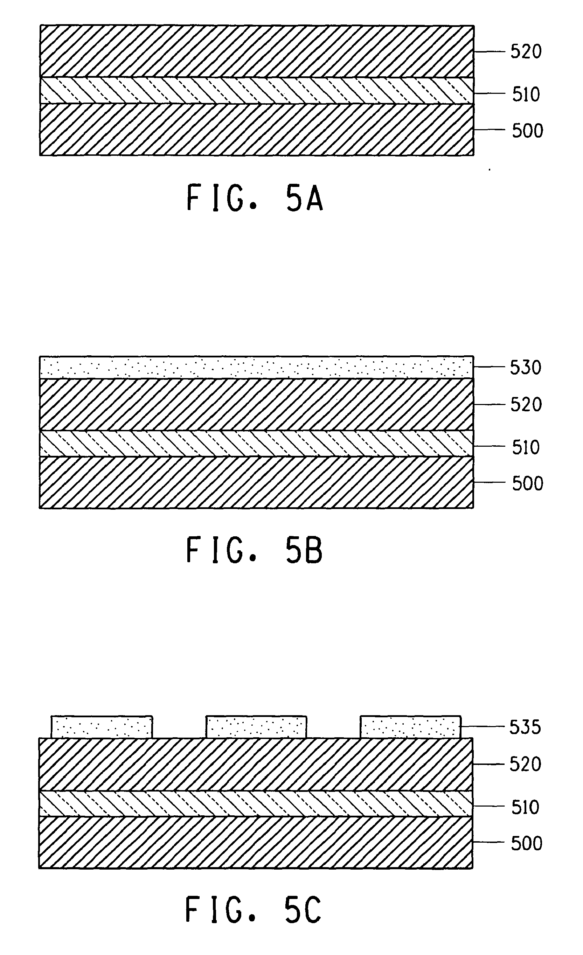

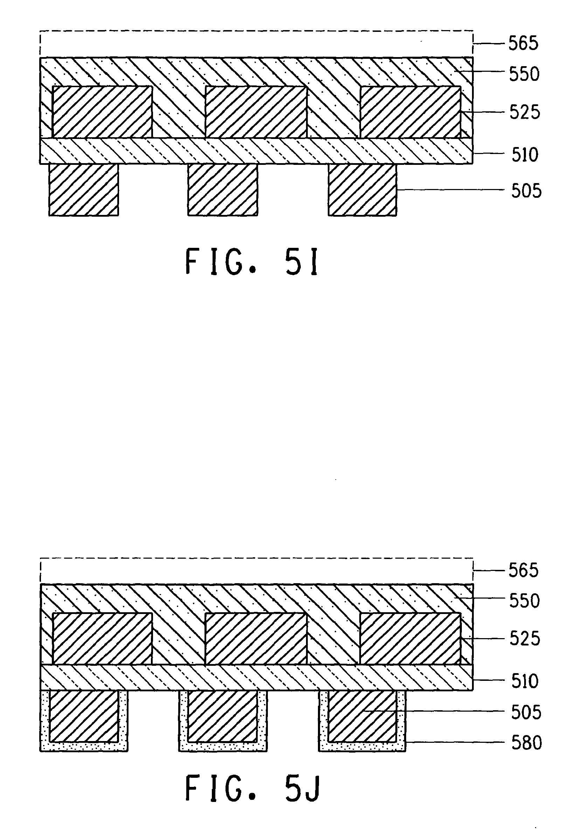

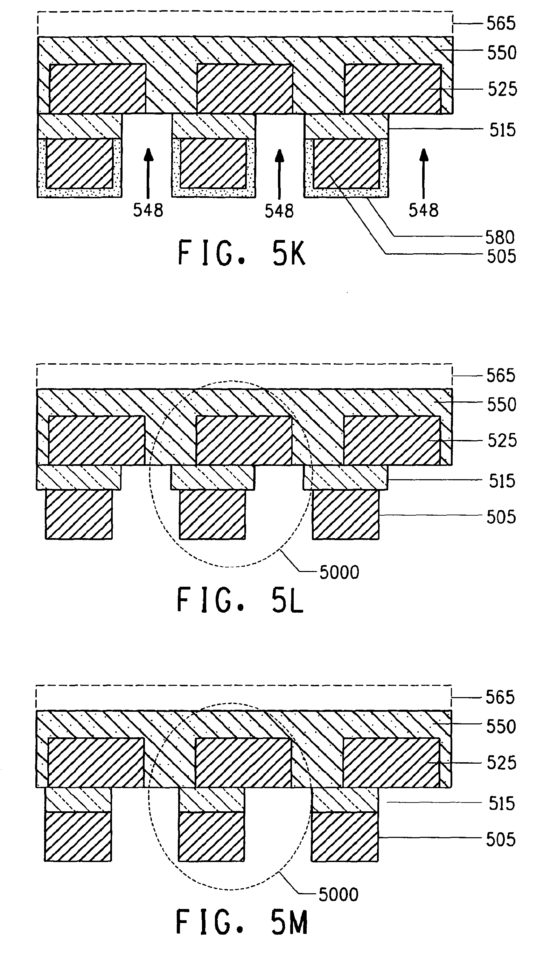

An alternate technique to form individual capacitors is shown in **FIGS. 5A-5M.** The metal/dielectric/metal structure, shown in **FIG. 1B,** is reproduced in **FIG. 5A,** having metal conductor **500,** dielectric **510,** and metal conductor **520.**

Referring to **FIG. 5B,** a photoresist material **530** is applied to the metal conductor **520.** The photoresist is imaged and developed to form the photomask **535** as shown in **FIG. 5C.**

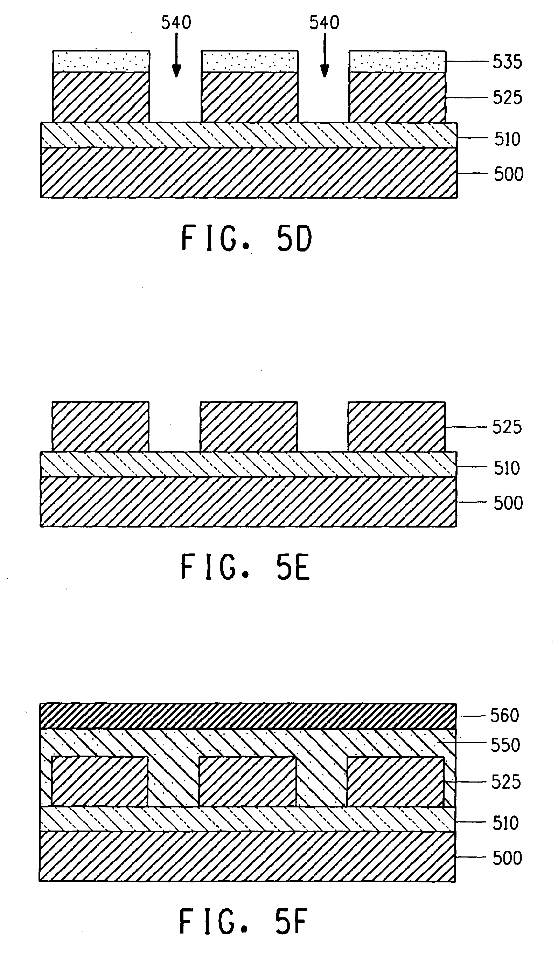

The article shown in **FIG. 5C** is now subjected to an alkaline etching bath. The alkali etching process removes the copper in the areas **540** shown in **FIG. 5D** and forms the first metal electrodes **525.** The alkaline etch does not attack or remove any of the dielectric **510.** The photomask **535** is subsequently removed by stripping (defined herein as removal), resulting in the structure shown in **FIG. 5E.**

A metal conductor **560** is laminated to the structure shown in **FIG. 5E** using an organic based dielectric layer such as a glass epoxy or other common organic dielectric prepreg **550** used in the printed wiring board industry to form the structure shown in **FIG. 5F.** This structure is typically called an innerlayer or subpart having metal conductors on each side and having metal electrodes **525** and thin ceramic dielectric **510** between the metal conductors **500** and **560.**

In some embodiments of the present invention an innerlayer is formed. This innerlayer comprises individual capacitors formed by an impingement process selected from the group comprising sandblasting, water impingement and chemical etching.

In further embodiments of the present invention a printed wiring board or organic semiconductor package substrate are formed comprising the inner layer(s) above.

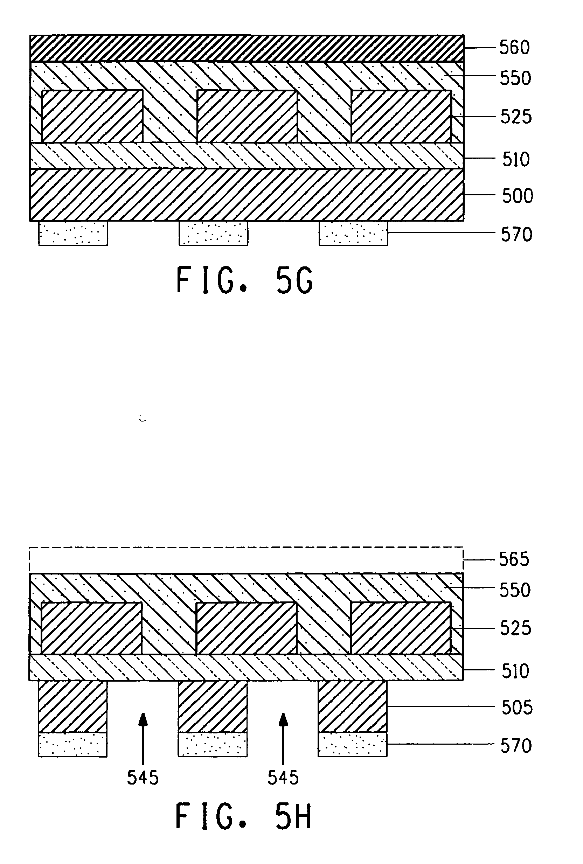

Referring to **FIG. 5G,** a photoresist is applied to metal conductors **500** and **560** and processed to create photomask **570.** Typically, but not always, the metal conductor **560** is removed in the area reserved for the formation of capacitors **5000** shown in **FIG. 5L,** thus no photomask **570** is shown on metal conductor **560.** Since a portion of metal conductor **560** may be present on an area not included in the diagrams, it is shown in **FIGS. 5H-5M** by dotted lines **565** for reference.

The article shown in **FIG. 5G** is now subjected to an alkaline etching bath. The alkali etching process removes portions of the metal conductor **500** in the areas **545** shown in **FIG. 5H** and forms the second metal electrodes **505.** The alkaline etch does not attack or remove any of the dielectric **510.**

Referring to **FIG. 51,** the photomask **570** may now be removed and replaced by another photoresist that is imaged to form the photomask **580** shown in **FIG. 5J.** Portions of the thin ceramic dielectric **510** may now be removed by sandblasting in the areas **548** as shown in **FIG. 5K,** leaving thin dielectric **515.** The first metal electrodes **525,** the thin dielectric **515** and second metal electrodes **505** form capacitors **5000** shown in **FIG. 5L.**

Referring to **FIG. 51,** the second metal electrodes **505** may be used as a mask for sandblasting the thin ceramic dielectric **510** to create the structure shown in **FIG. 5M.**

Sandblasting, as used herein, may not necessarily use sand as the blasting media. Sandblasting can use sand, aluminum oxide, glass beads or organic materials that have a hardness (Mohs scale) in the range of 5.5 to 9.0. A high hardness of the blasting media is desirable so that the ceramic dielectric is rapidly removed. Alternative physical means of removing the dielectric and metallic (typically copper) layer may be employed, such as water jet processes that may consist of abrasive slurries or even pure water.

## Claims

1. A method of making individual formed-on-foil thin ceramic capacitors comprising:
providing a structure, said structure comprising, in order, layers of a first metallic conductor, a ceramic dielectric, and a second metallic conductor;
forming a photo-definable mask over at least one of said metallic conductors, thus forming an article comprising a first photo-definable mask with underlying first metallic conductor; a ceramic dielectric and an opposing second metallic conductor; and
removing selected portions of said first photo-definable mask and said underlying first metallic conductor to form a patterned first side of said article comprising a first metallic electrode.

2. The method of claim 1 further comprising removing selected portions of the ceramic dielectric.

3. The method of claim 1 or claim 2 wherein the individual formed-on-foil thin ceramic capacitors are laminated to an organic dielectric layer.

4. The method of any of claims 1 to 3 wherein selected portions of at least one of the underlying first metallic conductor and the ceramic dielectric and the opposing metallic conductor are removed by a process selected from the group consisting of sandblasting, water impingement, and chemical etching.

5. The method of any of claims 1 to 4 further comprising the step of essentially completely removing the first photo-definable mask, thus forming an essentially mask-free patterned first side of said article.

6. The method of claim 2, wherein the first photo-definable mask is removed completely, thus forming a structure comprising both exposed and protected ceramic dielectric wherein the protected ceramic dielectric is covered by the first metallic electrode and wherein the exposed ceramic dielectric is removed.

7. An inner layer comprising individual capacitors formed by an impingement process selected from the group consisting of sandblasting, water impingement and chemical etching.

8. A printed wiring board or organic semiconductor package substrate comprising the inner layer of claim 7.
